# EUROPEAN PATENT APPLICATION

(11) **EP 1 057 578 A2**
(43) Date of publication of application: **06.12.2000**
(21) Application number: 00110832.3
(22) Date of filing: 22.05.2000
(51) Int. Cl.: B23K 26/00, B23K 26/08

(54) **Laser marking system and method**

(30) Priority: 25.05.1999 JP 14520599
(71) Applicant: Ando Electric Co., Ltd., Tokyo 144-0052 (JP)
(72) Inventor: Kudoh, Tetsuya, c/o Ando Electric Co., Ltd., Tokyo (JP); Tanaka, Yasuhiro, c/o Ando Electric Co., Ltd., Tokyo (JP)
(74) Representative: Grünecker, Kinkeldey, Stockmair & Schwanhäusser Anwaltssozietät

(57) **Abstract**

A laser beam (4) output from an LD (1) is transmitted over a fiber (2) and is output to an emission section (3). The laser beam (4) is converged, by a lens (5), to a beam spot substantially equal in size with the core diameter of the fiber (2), and the thus-converged laser beam is radiated onto a workpiece (7). An moving element (8) having an emission section (3) is moved under the control of an NC control circuit (15), thus making a mark on the surface of the workpiece (7) in accordance with the input instruction or marking pattern entered from external equipment (14). In the case of an increase in the temperature of the heat developing in the LD1, a Peltier control circuit (11) absorbs the heat of the LD1 through use of a Peltier element (10), and the thus-absorbed heat is radiated to the outside by way of the surface of a fin (16).

## Description

### BACKGROUND OF THE INVENTION

### 1. Field of the Invention

The present invention relates to a laser marking system and method in which a mark is made on the surface of a workpiece by means of vaporizing or burning the surface of the workpiece through exposure to a laser beam.

### 2. Description of the Related Art

In a commonly-known laser marking system, a workpiece made of resin, paper, or plastic of black or similar color is marked with; for example, a product lot number, a model name, a character, or a pattern, by means of vaporizing or burning the surface of the workpiece through exposure to a laser beam.

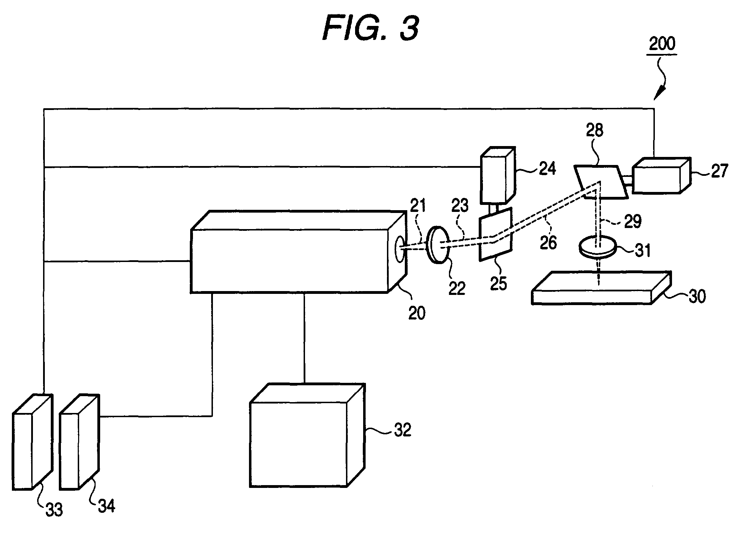

FIG. 3 is an illustration schematically showing a known laser marking system 200. As shown in FIG. 3, the laser marking system 200 employs a Yttrium Aluminum Garnet (YAG) laser 20 as a laser light source. A laser beam 21 output from the YAG laser 20 is collimated by means of a collimator lens 22. The thus-collimated laser beam 23 is deflected for scanning in the X-axis direction by means of a scanner 24 and a mirror 25 attached to the scanner 24. A laser beam 26 which has been deflected for scanning in the x-axis direction is further deflected for scanning in the Y-axis direction by means of another scanner 27 and a mirror 28 attached to the scanner 27. A laser beam 29 which has been deflected for scanning in both X-axis and Y-axis directions is converged and radiated onto a workpiece 30 by means of an Fθ lens (a lens for producing an image whose length is proportional to an incident angle θ of light as well as to a focal length F of a lens), thus marking the workpiece 30.

A cooler 32 is attached to the YAG laser 20 for cooling purposes, and a power supply 34 supplies power to the YAG laser 20 for causing the YAG laser 20 to oscillate. A controller 33 controls oscillation of the YAG laser 20 and scanning operations of the scanners 24 and 27. The controller 33 marks a character or a pattern on the workpiece 30 by means of changing the angle at which the laser beam 29 enters the Fθ lens 31, through use of the scanners 24 and 27, as well as by means of changing a target position of the laser beam 29 on the workpiece 30.

Radiating the laser beam 22 output from the YAG laser 21 onto an arbitrary position on the workpiece 30 involves complicated control of the optical axes of the collimator lens 22, the mirror 23, the mirror 25, and the Fθ lens 31. Further, even after adjustment, the optical axis of the optical system may become offset because of vibrations experienced during transportation. Each time the optical axis of an optical component becomes offset, the optical axis must be adjusted again, thus imposing a heavy burden on the user.

In view of emphasis on environmental issues, demand has recently arisen for an energy-saving, space-saving laser marking system. The laser beam 21 output from the YAG laser 20 involves a problem of low-grade beam quality or a like problem. For this reason, using a combination of optical lenses to reduce the diameter of a beam spot radiated onto the workpiece 30 is difficult. YAG laser usually realizes less-efficient conversion of energy into a laser beam. In order to make a mark on the workpiece 30 made of resin, paper, or plastic of black or similar color through use of the laser beam 21 output from the YAG laser 20, a power density of tens of kilowatts/cm² is required for marking at the wavelength of the laser beam 21. Attaining such a high power density involves use of the YAG laser 20 of high laser power in conjunction with a high-capacity power supply serving as the power supply 34. As a result, the amount of heat developing in the YAG laser 20 is increased, and the YAG laser 20 must be cooled through use of the cooler 32, thus inevitably rendering the marking system bulky.

### SUMMARY OF THE INVENTION

The present invention has been conceived to solve the foregoing problem and is aimed at providing a laser marking system and method which enables a reduction in the diameter of a laser beam spot and fulfils demands for energy and space conservation.

Accordingly, the present invention provides a laser marking system for making a mark on the surface of a workpiece by means of radiating a laser beam on the surface, the system comprising:
a laser diode (for example, an LD1) serving as a laser light source for outputting the laser beam;
transmission means (for example, a fiber 2) for transmitting the laser beam output from the laser diode;
radiation means (for example, a lens 5) for converging the laser beam transmitted over the transmission means and radiating the converged laser beam onto the surface of the workpiece; and
moving means (for example, a moving element 8) for moving a target position on the surface of the workpiece onto which the laser beam is to be radiated, according to a marking pattern and through use of the radiation means.

In the laser marking method of making a mark on the surface of a workpiece by means of radiating a laser beam on the surface, a laser light source for outputting the laser beam corresponds to a laser diode, and the transmission means transmits the laser beam output from the laser diode. The radiation means converges the laser beam transmitted over the transmission means and radiates the converged laser beam onto the surface of the workpiece. Further, the moving means moves a target position on the surface of the workpiece onto which the laser beam is to be radiated, according to a marking pattern and through use of the radiation means.

The present invention further provides a laser marking method of making a mark on the surface of a workpiece by means of radiating a laser beam on the surface, the system comprising:
a transmission step (embodied by, for example, an LD2) of transmitting the laser beam output from a laser diode (for example, an LD1) which serves as a laser light source for outputting the laser beam;
a radiation step (embodied by, for example, a lens 5) of converging the laser beam transmitted over the transmission means and radiating the converged laser beam onto the surface of the workpiece; and
a movement step (embodied by, for example, a moving member 8) of moving a target position on the surface of the workpiece onto which the laser beam is to be radiated, according to a marking pattern and through use of the radiation means.

In the laser marking method of making a mark on the surface of a workpiece by means of radiating a laser beam on the surface, in the transmission step there is transmitted the laser beam output from a laser diode which serves as a laser light source for outputting the laser beam. In the radiation step, there is converged the laser beam transmitted over the transmission means and radiating the converged laser beam onto the surface of the workpiece. In the movement step, there is moved a target position on the surface of the workpiece onto which the laser beam is to be radiated, according to a marking pattern and through use of the radiation means.

It is well known that a laser diode is compact and achieves good conversion efficiency. Therefore, a laser diode is employed as a laser light source in the laser marking system and method of the present invention, thereby rendering the laser marking system compact and fulfilling demands for space conservation. A laser beam originating from a laser diode which achieves high conversion efficiency is transmitted and radiated onto the surface of a workpiece, thus marking the workpiece. A power density required for marking the surface of the workpiece can be achieved by use of a low-capacity power supply, thus fulfilling demands for energy conservation.

Preferably, the transmission means transmits the laser beam output from the laser diode while using a fiber as a transmission path, and the radiation means converges the laser beam so that the laser beam assumes substantially the same size as the core diameter of the fiber, and radiates the laser beam on the surface of the workpiece.

In the laser marking method of making a mark on the surface of a workpiece by means of radiating a laser beam on the surface, the transmission means transmits the laser beam output from the laser diode while using a fiber as a transmission path, and the radiation means converges the laser beam so that the laser beam assumes substantially the same size as the core diameter of the fiber, and radiates the laser beam on the surface of the workpiece.

Preferably, in the transmission step there is transmitted the laser beam output from the laser diode while using a fiber as a transmission path. In the radiation step, there is converged the laser beam so that the laser beam assumes substantially the same size as the core diameter of the fiber and radiates the laser beam on the surface of the workpiece.

In the laser marking method of making a mark on the surface of a workpiece by means of radiating a laser beam on the surface, in the transmission step there is transmitted the laser beam output from the laser diode while using a fiber as a transmission path, and in the radiation step there is converged the laser beam so that the laser beam assumes substantially the same size as the core diameter of the fiber and radiates the laser beam on the surface of the workpiece.

Accordingly, a laser beam having a beam spot substantially equal in size with the core diameter of a fiber; i.e., a very small beam spot, can be radiated onto the surface of the workpiece. Therefore, the power density of the laser beam radiated onto the workpiece is increased, and a power density required for marking the surface of the workpiece can be achieved by use of a power supply of comparatively low capacity, thereby embodying energy conservation.

A laser beam is transmitted over a fiber serving as a transmission path, and hence the only required optical element is a lens for converging the laser beam, thus facilitating the control of the optical axis and the maintenance of the laser marking system and alleviating the burden imposed on the user.

Preferably, the laser marking system further comprises:
temperature detection means (for example, a thermocouple 17) for detecting an increase in the temperature of the laser diode serving as the laser light source, caused by heat developing in the laser diode;
heat absorbing means (for example, a Peltier element 10) for absorbing the heat when the temperature detection means has detected an increase in the temperature of the laser diode; and
heat radiation means (for example, a fin 16) for radiating, to the outside, the heat absorbed by the heat absorbing means.

In the laser marking system of the present invention, the temperature detection means detects an increase in the temperature of the laser diode serving as the laser light source, caused by heat developing in the laser diode, and the heat absorbing means absorbs the heat when the temperature detection means has detected an increase in the temperature of the laser diode. Further, the heat radiation means radiates, to the outside, the heat absorbed by the heat absorbing means.

Preferably, the laser marking method of the present invention further comprises:
a temperature detection step (embodied by, for example, a thermocouple 17) of detecting an increase in the temperature of the laser diode serving as the laser light source, caused by heat developing in the laser diode;
a heat absorbing step (embodied by, for example, a Peltier element 10) of absorbing the heat when the temperature detection means has detected an increase in the temperature of the laser diode; and
a heat radiation step (embodied by, for example, a fin 16) of radiating, to the outside, the heat absorbed by the heat absorbing means.

According to the laser marking method of the present invention, in the temperature detection step there is detected an increase in the temperature of the laser diode serving as the laser light source, caused by heat developing in the laser diode. In the heat absorbing step, there is absorbed the heat when the temperature detection means has detected an increase in the temperature of the laser diode, and in the heat radiation step there is radiated, to the outside, the heat absorbed by the heat absorbing means.

In the laser marking system and the laser marking method of the invention, when the temperature of a laser diode serving as a laser light source is increased by the heat developing in the laser diode, the heat can be absorbed and radiated, thus enabling cooling of the laser diode. Further, the laser diode achieves superior conversion efficiency and produces heat in a comparatively small amount, thus eliminating the necessity for a cooling device such as a cooler and enabling space conservation.

### BRIEF DESCRIPTION OF THE DRAWINGS

FIG. 1 is a block diagram schematically showing the configuration of a laser marking system 100 according to an embodiment of the present invention;
FIG. 2 is an illustration showing the manner in which a laser beam 4 shown in FIG. 1 is output from an emission section 3; and
FIG. 3 is an illustration schematically showing the configuration of a known laser marking system 200.

### DETAILED DESCRIPTION OF THE PREFERRED EMBODIMENTS

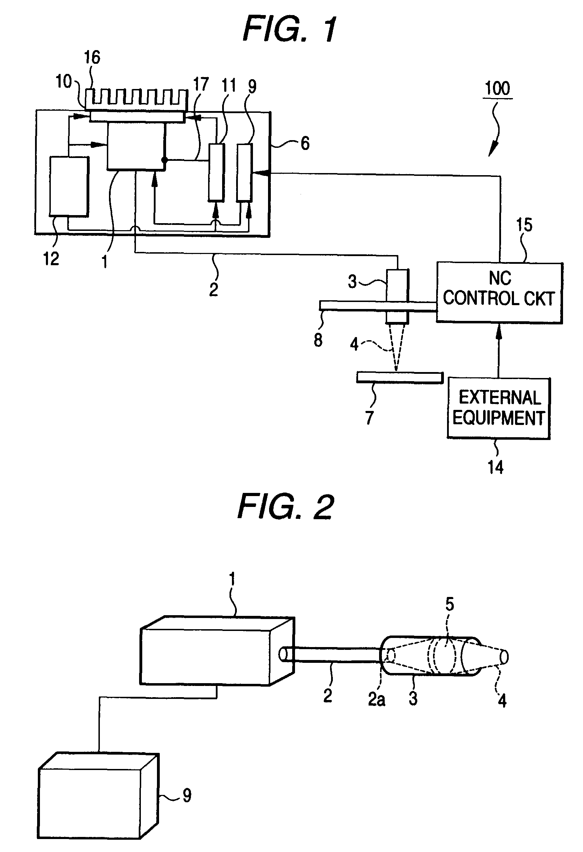

A laser marking system according to a preferred embodiment of the present invention will be described hereinbelow by reference to FIGS. 1 and 2.

FIG. 1 is a block diagram schematically showing the structure of a laser marking system 100 according to the present invention. As shown in FIG. 1, the laser marking system 100 comprises an LD controller 6, an emission section 3, a moving member 8, and a numerically-controlled (NC) control circuit 15. External equipment 14 consisting of a personal computer or a sequencer is connected to the NC control circuit 15.

The LD controller 6 is made up of a laser diode (LD) 1 having a fiber 2 attached thereto, an LD control circuit 9, a Peltier element 10, a Peltier control circuit 11, a power supply 12, and a thermocouple 17. Further, a fin 16 to be used for radiating the heat absorbed by the Peltier element 10 is attached to the outside of the LD controller 6.

The LD 1 and the fiber 2 are embodied by, for example, an LD having a fiber coupling. In accordance with a control signal output from the LD control circuit 9, the LD 1 converts the electric power supplied by the power supply 12 into a laser beam 4, and the laser beam 4 is output to the fiber 2. The fiber 2 is connected to the LD 1 and the emission section 3. The laser beam 4 output from the LD 1 is transmitted over the fiber 2 and is output to the emission section 3.

In accordance with a laser output signal output from the NC control circuit 15, the LD control circuit 9 outputs, to the LD 1, a control signal for causing the LD 1 to start or stop emission of the laser beam 4.

The Peltier element 10 is supplied with an electric current from the Peltier control circuit 11 such that the side of the Peltier element 10 adjacent to the LD 1 becomes the heat-absorbing side and the side of the Peltier element 10 adjacent to the fin 16 becomes the heat-radiating side. The heat developing in the LD 1 is absorbed by the Peltier element 10, and the thus-absorbed heat is released to the outside by way of the fin 16. In accordance with a detection signal output from the thermocouple 17 attached to the LD 1, the Peltier control circuit 11 supplies an electric current to the Peltier element 10.

The thermocouple 17 is attached to the LD 1 and detects the temperature of the LD 1. The corresponding detection signal is output to the Peltier control circuit 11. In order to increase an area to be used for radiating heat, the fin 16 is formed from a plurality of plates. The heat developing in the Peltier element 10, which stems from absorption of the heat produced by the LD 1, is radiated to the outside by way of the surfaces of the plates.

The power supply 12 corresponds to a 100V-AC power source having a capacity of about 2.8 amperes and supplies power to the LD 1, the LD control circuit 9, the Peltier element 10, and the Peltier control circuit 11.

As shown in FIG. 2, the emission section 3 is formed from a cylinder made from metal or a like material (the emission section will hereinafter be often referred to as a "cylindrical section"), and a lens 5 is housed in the cylindrical emission section 3. FIG. 2 is a schematic representation showing the way in which the laser beam 4 is output from the laser marking system 100. As shown in FIG. 2, in accordance with a control signal output from the LD control circuit 9, the LD 1 outputs, by way of the fiber 2, the laser beam 4 to the emission section 3 from a tip end 2a of the fiber 2. The laser beam 4 having entered the emission section 3 from the tip end 2a of the fiber 2 is scattered in accordance with the numerical aperture (NA) of the fiber 2. The thus-scattered laser beam 4 is converged by the lens 5, and the thus-converged laser beam is emitted to the outside by way of an open end of the emission section 3. The emission section 3 has a pen-like structure, in which the laser beam 4 which has been scattered by the lens 5 provided in the cylindrical section is output from an open end of the cylindrical section. The emission section 3 is attached to the moving element 8, so that the laser beam 4 converged by the lens 5 is radiated onto the workpiece 7.

The lens 5 of the emission section 3 is disposed at a position spaced twice the focal length of the lens 5 away from the tip end 2a of the fiber 2. Further, the lens 5 has a diameter which enables entry, into the lens 5, of all the scattered laser beams 4 diffused by the NA of the fiber 2. The distance between the tip end 2a of the fiber 2 from where the laser beam 4 begins to scatter and the lens 5 is twice the focal length of the lens 5. Hence, the laser beam 4 converged by the lens 5 forms an image substantially equal in size with the core diameter of the fiber 2, at a position spaced twice the focal length of the lens 5 away from the lens 5. Therefore, so long as the workpiece 7 is placed at the position spaced twice the focal length of the lens 5 away from the lens 5, a laser beam spot substantially equal to the core diameter of the fiber 2 can be radiated onto the workpiece 7.

The moving element 8 is formed from a robot effecting movement in orthogonal directions or a like robot and retains the emission section 3 attached thereto. In accordance with a numerical signal output from the NC control circuit 15, the moving element 8 travels, to thereby move a beam spot of the laser beam 4 which has been output from the emission section 3 attached to the moving element 8 and is radiated onto the surface of the workpiece 7. The emission section 3 may be made removable.

The NC control circuit 15 outputs a numerical signal to be used for moving the moving element 8, in accordance with an input instruction and a marking pattern entered from the external equipment 4. Further, the NC control circuit 15 outputs, to the LD control circuit 9 provided in the LD controller 6, a laser output signal for causing the LD 1 to start or stop emission of the laser beam 4.

The external equipment 14 is formed of a personal computer or a sequencer and outputs an instruction or a marking pattern for causing the NC control circuit 15 to perform a marking operation.

The operation of the marking system will now be described.

Upon receipt, from the external equipment 14, of an instruction for effecting a marking operation and a marking pattern, the NC control circuit 15 outputs a laser output signal for moving the moving element 8 to a predetermined position according to the input marking pattern and causing the LD control circuit 9 provided in the LD controller 6 to output the laser beam 4 from the LD 1. In accordance with the laser output signal output from the NC control circuit 15, the LD control circuit 9 causes the LD 1 to output the laser beam 4 to the emission section 3 by way of the fiber 2. Through use of the lens 5, the emission section 3 converges the laser beam 4 which has been input by way of the fiber 2, thereby radiating the thus-converged laser beam 4 onto the surface of the workpiece 7.

Subsequently, the NC control circuit 15 moves the moving element 8 in accordance with the marking pattern input from the external equipment 14 and makes a mark on the surface of the workpiece 7 through use of the laser beam 4 output from the emission section 3. After completion of the movement of the moving element 8 according with the marking pattern, the NC control circuit 15 outputs, to the LD control circuit 9 provided in the LD controller 6, a laser output signal for stopping output of the laser beam 4. In accordance with the laser output signal, the LD control circuit 9 causes the LD 1 to stop emission of the laser beam 4.

When the temperature of the LD 1 is increased by the heat developing in the LD 1 while the LD 1 is outputting the laser beam 4, the Peltier control circuit 11 supplies an electric current to the Peltier element 10 in accordance with the detection signal entered from the thermocouple 17 attached to the LD 1. Accordingly, the Peltier element 10 absorbs the heat developing in the LD 1. The heat absorbed by the Peltier element 10 is radiated to the outside by way of the surface of the fin 16, thus cooling the LD 1.

As has been described above, the laser beam 14 output from the LD 1 is transmitted over the fiber 2 and is output to the emission section 3. The laser beam 4 is converged, by means of the lens 5, to a beam spot substantially equal in size with the core diameter of the fiber 2, and the thus-converged laser beam is radiated onto the workpiece 7. The moving element 8 having the emission section 3 is moved under the control of the NC control circuit 15, thus making a mark on the surface of the workpiece 7 in accordance with the input instruction or marking pattern entered from the external equipment 14. In the case of an increase in the temperature of the heat developing in the LD1, the Peltier control circuit 11 absorbs the heat of the LD1 through use of the Peltier element 10, and the thus-absorbed heat is radiated to the outside by way of the surface of the fin 16.

Accordingly, a beam spot substantially equal in size with the core diameter of the fiber 2; i.e., a small beam spot, can be radiated onto the workpiece 7. Since the LD1 converts energy into the laser beam 4 efficiently, a power density sufficient for marking can be obtained by a power supply 12 of comparatively low capacity, thus enabling energy conservation.

The LD1 achieves superior conversion efficiency and produces a smaller amount of heat. Therefore, the LD1 can be cooled through natural cooling action effected by the fin 16, thus eliminating the necessity for use of a cooling device such as the cooler 32. Further, the LD1 is a more compact laser, thus enabling space conservation.

The optical element used in the laser marking system 100 corresponds to merely the lens 5, thus eliminating the need for a collimator lens, an Fθ lens, a scanner, and a mirror. Therefore, adjustment of the optical axis and maintenance of the marking system 100 are facilitated, thus alleviating a burden imposed on the user.

In the present embodiment, the laser marking system 100 is configured so as to use the LD1 attached to the fiber 2 as the light source and to output a laser beam to the emission section 3 attached to the moving element 8. However, the present invention is not limited to such a configuration. For example, the laser marking system 100 may be arranged such that the LD1 is attached to the moving element 8, and a laser beam output from the LD1 is converged by the lens 5 so as to fall on the workpiece 7. Even other minute portions of the configuration of the laser marking system may be changed, as required, within the scope of the invention. Further, a laser beam whose beam spot is smaller than the core diameter of the fiber 2 may be radiated onto the workpiece 7, by means of changing the combination of optical lenses.

It is well known that a laser diode is compact and achieves good conversion efficiency. Therefore, a laser diode is employed as a laser light source in the laser marking system and method of the present invention, thereby rendering the laser marking system compact and fulfilling demands for space conservation. A laser beam originating from a laser diode which achieves high conversion efficiency is transmitted and radiated onto the surface of a workpiece, thus marking the workpiece. A power density required for marking the surface of the workpiece can be achieved by use of a low-capacity power supply, thus fulfilling demands for energy conservation.

In the laser marking system and the laser marking method of the invention, a laser beam having a beam spot substantially equal in size with the core diameter of a fiber; i.e., a very small beam spot, can be radiated onto the surface of the workpiece. Therefore, the power density of the laser beam radiated onto the workpiece is increased, and a power density required for marking the surface of the workpiece can be achieved by use of a power supply of comparatively low capacity, thereby embodying energy conservation.

A laser beam is transmitted over a fiber serving as a transmission path, and hence the only required optical element is a lens for converging the laser beam, thus facilitating the control of the optical axis and the maintenance of the laser marking system and alleviating the burden imposed on the user.

In the laser marking system and the laser marking method of the invention, when the temperature of a laser diode serving as a laser light source is increased by the heat developing in the laser diode, the heat can be absorbed and radiated, thus enabling cooling of the laser diode. Further, the laser diode achieves superior conversion efficiency and produces heat in a comparatively small amount, thus eliminating the necessity for a cooling device such as a cooler and enabling space conservation.

## Claims

1. A laser marking system for making a mark on the surface of a workpiece by radiating a laser beam on the surface, the system comprising:
a laser diode serving as a laser light source for outputting the laser beam;
transmission means for transmitting the laser beam output from the laser diode;
radiation means for converging the laser beam transmitted over the transmission means and radiating the converged laser beam onto the surface of the workpiece; and
moving means for moving a target position on the surface of the workpiece onto which the laser beam is to be radiated, according to a marking pattern and through use of the radiation means.

2. The laser marking system as defined in claim 1, wherein the transmission means transmits the laser beam output from the laser diode while using a fiber as a transmission path, and the radiation means converges the laser beam so that the laser beam assumes substantially the same size as the core diameter of the fiber, and radiates the laser beam on the surface of the workpiece.

3. The laser marking system as defined in claim 1 or 2, further comprising:
temperature detection means for detecting an increase in the temperature of the laser diode serving as the laser light source, caused by heat developing in the laser diode;
heat absorbing means for absorbing the heat when the temperature detection means has detected an increase in the temperature of the laser diode; and
heat radiation means for radiating, to the outside, the heat absorbed by the heat absorbing means.

4. A laser marking method of making a mark on the surface of a workpiece by means of radiating a laser beam on the surface, the method comprising:
a transmission step of transmitting the laser beam output from a laser diode which serves as a laser light source for outputting the laser beam;
a radiation step of converging the laser beam transmitted over the transmission means and radiating the converged laser beam onto the surface of the workpiece; and
a movement step of moving a target position on the surface of the workpiece onto which the laser beam is to be radiated, according to a marking pattern and through use of the radiation means.

5. The laser marking method as defined in claim 4, wherein in the transmission step there is transmitted the laser beam output from the laser diode while using a fiber as a transmission path, and in the radiation step there is converged the laser beam so that the laser beam assumes substantially the same size as the core diameter of the fiber and radiates the laser beam on the surface of the workpiece.

6. The laser marking method as defined in claim 4, further comprising:
a temperature detection step of detecting an increase in the temperature of the laser diode serving as the laser light source, caused by heat developing in the laser diode;
a heat absorbing step of absorbing the heat when the temperature detection means has detected an increase in the temperature of the laser diode; and
a heat radiation step of radiating, to the outside, the heat absorbed by the heat absorbing means.
